# EUROPEAN PATENT APPLICATION

(11) **EP 4 407 330 A1**
(43) Date of publication of application: **31.07.2024**
(21) Application number: 21968429.7
(22) Date of filing: 20.12.2021
(51) Int. Cl.: G01R 31/382

(54) **BATTERY MONITORING SYSTEM, BATTERY AND ELECTRIC APPARATUS**

(71) Applicant: Contemporary Amperex Technology Co., Limited, Ningde, Fujian 352100 (CN)
(72) Inventor: JIA, Hui, Ningde, Fujian 352100 (CN); DAI, Lifeng, Ningde, Fujian 352100 (CN); XIE, Jihai, Ningde, Fujian 352100 (CN)
(74) Representative: Behr, Wolfgang
(86) International application number: PCT/CN2021/139757
(87) International publication number: WO 2023/115273

(57) **Abstract**

The present application relates to the field of batteries (100), and in particular to a battery monitor system (30), a battery (100), and an electrical device (1000). In the battery monitor system (30), in case that the master monitor component (31) is in a wake-up mode, the master monitor component (31) and N sensor components (32) can jointly monitor abnormal conditions of each cell module (20) in the battery (100). In case that the master monitor component (31) is in a sleep mode, the N sensor components (32) periodically monitor abnormalities, and the power consumption is lower. In case that an abnormality is detected by any sensor component (32), other sensor components (32) subsequent to this sensor component (32) can be awakened in reverse sequence via the serial communication network, and then the master monitor component (31) can be awakened by the last sensor component (32) to conduct a comprehensive monitoring and report abnormal faults. Thus, the safety of the battery can also be monitored by the battery monitor system (30) in real time with low power (100) consumption even when the battery monitor system (30) is in the sleep mode.

## Description

### TECHNICAL FIELD

The present application relates to the field of batteries, and in particular, to a battery monitor system, a battery and an electrical device.

### BACKGROUND

With the development of green energy, batteries are used more and more widely, especially in the field of new energy vehicle, information home appliances or photovoltaic power generation that have emerged in recent years. Batteries are used as important energy storage and power supply equipment, such as, to supply power for new energy cars, terminal equipment, etc., and to store energy for solar panels.

To increase a capacity of the battery, the battery includes a plurality of cell modules connected in series, in parallel or in series-and-parallel, and each cell module includes a plurality of cells connected in series, parallel or in series-and-parallel. The battery may also include other structures, such as a converging component for realizing electrical connection between the plurality of cells, or a wire harness isolation plate assembly for realizing a series or parallel connection of the cells and realizing installation and fixing of sampling lines.

In addition to the above basic structure, the battery also includes a battery management system (BATTERY MANAGEMENT SYSTEM, BMS). The BMS is a protection and management unit specially designed for batteries, that applies a control algorithm for power supply to a driving load such as an engine, a measurement of electrical characteristics such as current and voltage, a charge and discharge control, a voltage balance control, a monitoring such as an evaluation for a state of charge (SOC) as well as an abnormality monitoring, and so on. However, after the electrical device is put into sleep, the BMS of the battery also enters a sleep mode, that is, a 24-hour real-time monitoring cannot be performed, resulting in an inability to accurately report abnormal faults.

### SUMMARY

In view of the above problems, the present application provides a battery monitor system, a battery and an electrical device. The battery monitor system can monitor the battery in real time for 24 hours with low power consumption, and when an abnormality is detected, the entire battery monitor system can be automatically awakened to perform a comprehensive monitoring.

In accordance with a first aspect, the present application provides a battery monitor system which includes N sensor components and a master monitor component. The N sensor components and a master monitor component are connected via a serial communication network. The N sensor components are configured to periodically monitor whether a corresponding cell module is abnormal, and N is an integer being greater than or equal to 2. If it is detected by an i-th sensor component that the cell module corresponding to the i-th sensor component is abnormal, then a wake-up signal is sent by the i-th sensor component via the serial communication network to enable other sensor components subsequent to the i-th sensor component on the serial communication network to be awakened in sequence, and the master monitor component is awakened by an awakened N-th sensor component, where 1≤i≤N.

In the above embodiment of the present application, for the above battery monitor system, in case that the master monitor component is in a wake-up mode, the master monitor component and the N sensor components can jointly monitor abnormal conditions of each cell module in the battery in an all-round way. In case that the master monitor component is in a sleep mode, the N sensor components periodically monitor abnormalities, and the power consumption is lower. In case that an abnormality is detected by any sensor component, the subsequent sensor components can be awakened in reverse sequence via the serial communication network, and then the master monitor component can be awakened by the last sensor component to conduct a comprehensive monitoring and report abnormal faults. Thus, the safety of the battery can also be monitored by the battery monitor system in real time with low power consumption even when the battery monitor system is in the sleep mode.

In a possible implementation of the first aspect, the serial communication network adopts a daisy chain communication.

In the above-mentioned embodiment of the present application, the serial communication network adopts the daisy chain communication, that is, the master monitor component and N sensor components are connected hand in hand by daisy chains to facilitate the transmission of wake-up signals. When a wake-up signal is sent by a sensor component to the serial communication network, other components can be awakened in turn.

In a possible implementation of the first aspect, the master monitor component includes a first pin and a second pin, the first pin and the second pin are respectively connected with the serial communication network, the first pin is configured to send a wake-up signal, the second pin is configured to receive the wake-up signal. A sensor component includes a third pin and a fourth pin, the third pin and the fourth pin are respectively connected with the serial communication network, the third pin is configured to receive the wake-up signal, and the fourth pin is configured to send the wake-up signal.

In the above embodiment of the present application, the master monitor component and each sensor component are connected through pins and a daisy chain to form a serial communication, the structure is simple, and no special requirement is needed for interfaces of the master monitor component and the sensor components, thus a strong universal applicability can be achieved. For example, when the master monitor component is a BMS and the sensor component is an air pressure sensor, most BMS and air pressure sensors on the market can be connected through their own pins and daisy chains.

In a possible implementation manner of the first aspect, the master monitor component and the N sensor components are also connected via a parallel communication network. The master monitor component is configured to send coding coordination information to the parallel communication network, and the N sensor components are configured to respectively perform an identifier encoding according to the coding coordination information.

In the above embodiment of the present application, the master monitor component and the N sensor components are also connected via a parallel communication network. In the initialization stage of the battery monitor system, the coding coordination information can be sent by the master monitor component to the parallel communication network, and the identifiers of the N sensor components are encoded according to the coding coordination information, so that automatic coding can be realized and the offline test and calibration process can be omitted.

In a possible implementation of the first aspect, the coding coordination information is sent by the master monitor component to the parallel communication network, and the wake-up signal is also sent by the master monitor component to the serial communication network. The i-th sensor component is awakened after receiving the wake-up signal, and the awakened i-th sensor component is configured to perform the identifier encoding according to the coding coordination information and the identifier information in the parallel communication network, and send i-th identifier information to the parallel communication network, and send the wake-up signal to the serial communication network, to enable other sensor components subsequent to the i-th sensor component to be woken up in sequence and to perform the identifier encoding according to the identifier information in the parallel communication network and the coding coordination information.

In the above-mentioned embodiment of the present application, during the initialization stage of the battery monitor system, the coded coordination information is sent by the master monitor component to the parallel communication network and the wake-up signal is sent by the same to the serial communication network, so that the N sensor components are awakened in turn, and the identifier encoding is performed according to the coding coordination information and the identifier information in the parallel communication network to realize an automatic coding, which is simple and convenient without additional settings.

In a possible implementation of the first aspect, the coding coordination information includes the number N of sensor components and a numerical range. A 1-st sensor component after being awakened uses an initial value of the numerical range as an identifier of the 1-st sensor component. Aj-th sensor component after being awakened uses an identifier of the (j-1)-th sensor component increased by 1 as an identifier of the j-th sensor component, where 2≤j≤N.

In the above embodiment of the present application, the N sensor components are awakened in sequence, and the identifiers are sequentially incremented by 1 during encoding, so that the identifiers will not be repeated, and the encoding process is simple and less error-prone.

In a possible implementation of the first aspect, the master monitor component is configured to verify whether a number of identifier information in the parallel communication network is matched with the number N of the sensor components after the identifier encoding is performed by each of the N sensor components, and determine an encoding failure if the number of identifier information in the parallel communication network is not matched with the number N of the sensor components, and re-send the wake-up signal to the serial communication network, to enable the N sensor components to respectively re-perform the identifier encoding. The master monitor component is configured to determine an occurrence of an automatic encoding failure if a number of successive encoding failures reaches a preset number.

In the above embodiment of the present application, after the identifier encoding is performed by each of the N-th sensor component, the master monitor component verifies whether the encoding of the entire system is successful by comparing the number of identifier information in the parallel communication network and the number of sensor components, if a number of successive encoding failures reaches a preset number, an automatic encoding failure will be reported, which enables the encoding process to be more intelligent, and will not cause an encoding failure due to accidental interference factors, the reliability is higher.

In a possible implementation of the first aspect, the master monitor component is configured to, if the wake-up signal sent by the N-th sensor component is not received by the master monitor component, determine that the serial communication network is faulty. The master monitor component is configured to, if the wake-up signal sent by the N-th sensor component is received by the master monitor component and the master monitor component verifies that the number of identifier information in the parallel communication network is not matched with the number N of the sensor components, determine that the parallel communication network is faulty.

In the above embodiment of the present application, communication faults can be located by determinations on whether the wake-up signal is sent by the N-th sensor component, and whether the number of identifier information in the parallel communication network is matched with the number of sensor components, which is convenient for operators to repair.

In one possible implementation of the first aspect, the parallel communication network is a controller area network.

In the above embodiment of the present application, the master monitor component and the sensor components are connected in parallel communication via the controller area network, so that the signals sent by each component can be transmitted in real time.

In a possible implementation of the first aspect, the master monitor component also includes a fifth pin and a sixth pin, the fifth pin is in connection with a first communication line in the parallel communication network, and the sixth pin is in connection with a second communication line in the parallel communication network. Each sensor component also includes a seventh pin and an eighth pin, the seventh pin is connected to the first communication line, and the eighth pin is connected to the second communication line.

In the above embodiment of the present application, the pins are connected to the CAN bus to form a parallel communication, the structure is simple, and no special requirement is needed for the interfaces of the master monitor component and the sensor components, thus a strong universal applicability can be achieved. For example, when the master monitor component is a BMS and the sensor component is an air pressure sensor, most BMS and air pressure sensors on the market can be connected to the CAN bus through their own pins.

In accordance with a second aspect, the present application provides a battery, including the battery monitor system described in the first aspect and N cell modules, a sensor component is arranged corresponding to a cell module, and the master monitor component includes a battery management system (BMS).

In the above embodiments of the present application, the battery monitor system can monitor the battery in real time for 24 hours with low power consumption. In case that an abnormality is detected, the entire battery monitor system can be automatically awakened to perform a comprehensive monitoring, enabling the battery to be more reliable and safer.

In accordance with a second aspect, the present application provides an electrical device which includes the battery described in the second aspect.

In the above embodiments of the present application, based on the reliable and safe characteristics of the battery, the electric device can reduce losses caused by battery failure.

The above description is only an overview of the technical solutions of the present application. To better understand the technical means of the present application, to enable implementations according to the contents of the description, and to make the above and other objectives, features and advantages of the present application more obvious and understandable, the following will describe some specific implementations of the present application.

### BRIEF DESCRIPTION OF DRAWINGS

Various other advantages and benefits will become apparent to those of ordinary skills in the art upon reading the following detailed description of preferred embodiments. The drawings are intended only to illustrate the preferred embodiments and should not be considered as limitations of the present application. Also, the same reference numerals are used to denote the same components throughout the drawings. In the drawings:
FIG. 1 is a schematic structural diagram of an electric vehicle in accordance with some embodiments of the present application;
FIG. 2 is a schematic structural diagram of a battery in accordance with some embodiments of the present application;
FIG. 3 is a schematic structural diagram of a battery monitor system in accordance with some embodiments of the present application; and
FIG. 4 is a schematic structural diagram of a battery monitor system in accordance with some embodiments of the present application.

### DETAILED DESCRIPTION OF EMBODIMENTS

Technical solutions in embodiments of the present application will be described in detail below in conjunction with the drawings. The following embodiments are intended only to illustrate the technical solutions of the present application more clearly, and theretofore are merely some exemplary embodiments, and should not be considered as limitations to the protection scope of the present application.

Unless otherwise defined, all technical and scientific terms used herein have the same meaning as commonly-understood by those of ordinary skills in the technical field of the present application. The terms used herein are only for the purpose of describing specific embodiments, and are not intended to limit the present application. The terms "comprising" and "having" and any variations thereof in the specification and claims of the present application and in the description of the above drawings are intended to cover a non-exclusive inclusion.

In the description of the embodiments of the present application, technical terms such as "first" and "second" are only used to distinguish different objects, and should not be understood as indicating or implying relative importance or implicitly indicating a quantity, a specific order or a primary-secondary relationship of the indicated technical features. In the description of the embodiments of the present application, a phrase "a/the plurality of" means two or more, unless otherwise specifically defined.

Reference herein to an "embodiment" means that a particular feature, structure, or characteristic described in connection with the embodiment may be included in at least one embodiment of the present application. The mention of the wording "embodiment" in various parts of the specification are not necessarily all referring to the same embodiment, nor are separate or alternative embodiments mutually exclusive of other embodiments. It would be understood explicitly and implicitly by those skilled in the art that the embodiment described herein may be combined with other embodiments.

In the description of the embodiment of the present application, the term "and/or" is only an association relationship describing associated objects, which indicates that there may be three kinds of relationships, for example, A and/or B may include three cases that: A exists alone, A and B exist simultaneously, and B exists alone. In addition, the character "/" inhere generally indicates that the associated objects are in an "or" relationship.

In the description of the embodiments of the present application, the term "multiple" refers to more than two (including two), similarly, "multiple groups" refers to more than two groups (including two groups), and "multiple pieces" refers to more than two pieces (including two pieces).

In the description of the embodiments of the present application, the orientation or positional relationship indicated by technical terms, such as "center", "longitudinal", "lateral", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc. is based on the orientation or positional relationship shown in the drawings, which is used only for the convenience of describing the embodiment of the present application and simplifying the description, and does not indicate or imply that the device or element referred to must have a specific orientation, be constructed and operated in a specific orientation, and therefore cannot be understood as limitations to the embodiments of the present application.

In the description of the embodiments of the present application, unless otherwise expressly specified and defined, terms such as "installation", "connected to", "coupled to", "fixation", etc., should be interpreted in a broad sense, for example, it may be a fixed connection or a detachable connection, or an integration; it may be a mechanical connection or an electrical connection; it may be a direct connection or an indirect connection through an intermediary; and it may be an internal communication between two components or an interaction between two components. For those of ordinary skills in the art, the specific meanings of the above terms in the embodiments of the present application can be understood according to specific situations.

During charging, the battery is capable of converting electrical energy into chemical energy, and during discharging, the battery is capable of converting the chemical energy into the electrical energy, so that an energy conversion can be achieved. No by-products that pollute the environment will be produced in the process of energy conversion, which has advantages of energy environmental protection and energy saving. In addition, it is easy for the battery to be widely used in various products, and in some embodiments, the battery is applied to portable devices (for example, a terminal product such as a mobile phone) to provide power for the portable devices. In some embodiments, the battery may also be applied to electric vehicles (EV) or hybrid vehicles (HV), etc., to provide power for the vehicles and reduce carbon emissions. In some embodiments, the battery may also be used in energy storage systems, such as storing energy for solar panels in photovoltaic power generation.

Generally, a battery includes a plurality of cell modules connected in series, in parallel, or in series-and-parallel, and each cell module includes a plurality of cells connected in series, in parallel or in series-and-parallel. The battery may also include other structures, such as a converging component for realizing electrical connection between the plurality of cells, or a wire harness isolation plate assembly for realizing series and parallel connection of the cells and realizing installation and fixing of sampling lines. The battery also includes a battery management system (BMS), which is responsible for monitoring an operation status of each cell module in the battery to ensure a safe and reliable operation of each cell module. The BMS can monitor and collect internal and external status parameters of each cell module in real time (including but not limited to a voltage, a temperature, a current, an air pressure, a gas or smoke, etc.), and perform necessary analysis and calculation on relevant status parameters to acquire more evaluation parameters of system status. An effective management and control of the battery is implemented according to a specific protection control strategy, so as to ensure the safe and reliable operation of the entire battery. Meanwhile, the BMS can exchange information with other external equipment (such as fire protection system) through a communication interface and an analog/digital input and output interface of the BMS to form a linkage control, to ensure the safe and reliable operation of the battery-powered electric device.

It is noted by inventors of the present application that after the electric device is put to sleep, the BMS of the battery also enters a sleep mode, that is, the battery cannot be monitored in real time for 24 hours, resulting in the inability to accurately report abnormal faults.

For example, in case that the electrical device is an electric vehicle, most of the electronic control units (ECUs) should be in a power-off state when the electric vehicle is in the sleep mode, and some ECUs that receive wake-up outside the vehicle remain in a wake-up detection mode and need to be connected to a power supply. In electric vehicles, generally an additional lead-acid battery (output a small voltage, such as 12V, etc.) is provided to supply power to an electric drive system and an ignition system within a short time during an initiation of the electric drive system. After the electric vehicle is ignited and started, the electric drive system converts the electrical energy output by the battery (that is, the above-mentioned battery including the BMS, which outputs a large voltage, such as 300V-600V, etc.) into mechanical energy to drive the electric vehicle. After the electric vehicle is started, the battery powers the EV and also charges the lead-acid battery. It can be understood that the electric vehicle includes the lead-acid battery for powering the ignition system and some ECUs in the sleep mode and the battery for powering the entire vehicle in a driving mode.

In the electric vehicle, the BMS is powered by the lead-acid battery. After the electric vehicle enters the sleep mode, the BMS of the battery also enters the sleep mode (i.e., a standby mode that is powered on but is not in operation), that is, the battery cannot be monitored in real time for 24 hours.

It can be understood that in other electrical devices, the BMS of the battery is self-powered and has a self-starting sleep mechanism, which also cannot monitor the battery in real time for 24 hours.

Based on the above considerations, it is noted by the inventors of the present application based on research that a battery monitor system is designed, including N sensor components and a master monitor component that are connected via a serial communication network (N is an integer that is greater than or equal to 2). For example, The N sensor components are arranged in a one-to-one correspondence with the N cell modules, and the N sensor components are configured to periodically monitor whether the corresponding cell modules are abnormal. On the basis of the periodic real-time monitoring characteristics of the sensor components, 24-hour real-time monitoring can be realized.

On the basis of the connection between the master monitor component and N sensor components via a serial communication network, when it is detected by an i-th sensor component that the cell module corresponding to the i-th sensor component is abnormal, a wake-up signal is sent by the i-th sensor component via the serial communication network, so that other sensor components subsequent to the i-th sensor component on the serial communication network are awakened in sequence, and the master monitor component is awakened by the awakened N-th sensor component. Therefore, in case that an abnormality is detected by any one of the sensor components, a wake-up signal is sent to the serial communication network, so that the master monitor component can be awakened in time to perform a comprehensive monitoring and report abnormal faults when the battery is abnormal.

That is to say, for the above battery monitor system, in a case that the master monitor component is awakened, the master monitor component and the N sensor components can jointly monitor the abnormality of each cell module in the battery in an all-round way.

In a case that the master monitor component is in sleep, the N sensor components periodically monitor abnormalities, and the power consumption is lower. In case that an abnormality is detected by any sensor component, the subsequent sensor components are awakened in reverse sequence via the serial communication network, and then the master monitor component is awakened by the last sensor component to conduct the comprehensive monitoring and report the abnormal faults. Thus, the safety of the battery can also be monitored by the battery monitor system in real time with low power consumption even when the battery monitor system is in the sleep mode.

The battery monitor system provided in the embodiments of the present application is applied to a battery, for example, the battery monitor system may be encapsulated inside the battery. The battery including a battery monitor system may, but not limited to, be used in electrical devices such as vehicles, watercrafts, aircrafts, etc., and may also be used in storage devices such as inverters or photovoltaic power generation. In this way, the battery monitor system can monitor the battery in real time for 24 hours with low power consumption, and the entire battery monitor system can be automatically awakened to perform an all-round monitoring when an abnormality is detected, which is beneficial to the safety of electrical devices and storage devices.

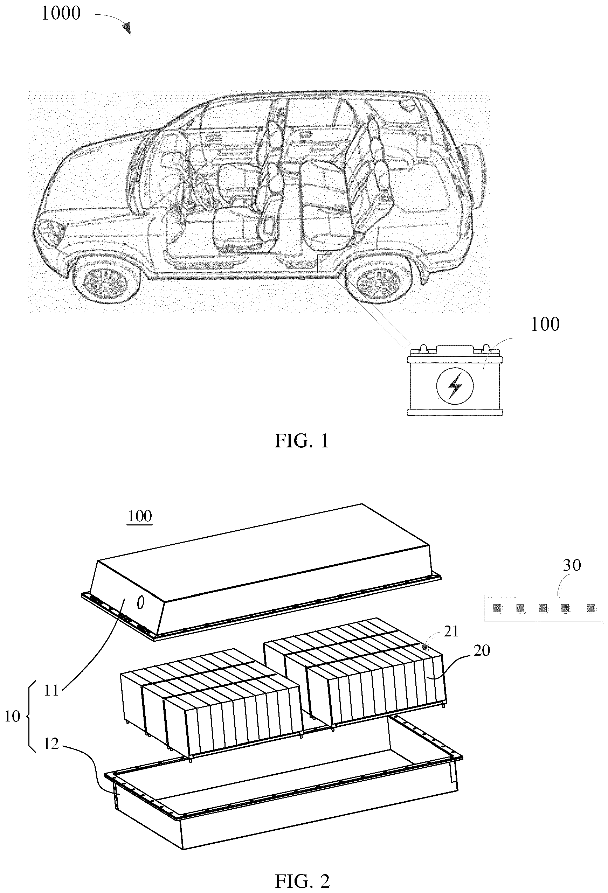

An embodiment of the present application provides an electrical device, which may be, but not limited to, a vehicle, a watercraft, or an aircraft. In the following embodiments, for the convenience of description, an electric vehicle is taken as an example for illustration in an embodiment of the present application. As shown in FIG. 1, a battery 100 is provided inside an electric vehicle 1000.

The battery 100 may be arranged at the bottom, head or tail of the electric vehicle 1000. The battery 100 may be used as a driving power source of the electric vehicle 1000 to replace or partially replace the fuel oil or natural gas to provide a driving power for the electric vehicle 1000.

Referring to FIG. 2, FIG. 2 is an exploded view of a battery 100 according to some embodiments of the present application. The battery 100 includes a box body 10, a plurality of cell modules 20 and a battery monitor system 30, and the plurality of cell modules 20 and the battery monitor system 30 are housed in the box body 10. Inhere, the box body 10 is configured to accommodate the plurality of cell modules 20 and the battery monitor system 30, and the box body 10 may have various structures. In some embodiments, the box body 10 may include a first part 11 and a second part 12, the first part 11 are the second part 12 are engaged with each other, and the first part 11 and the second part 12 jointly define an accommodation space. The second part 12 may be a hollow structure having one side opening, the first part 11 may be a plate-like structure, and the first part 11 is covered on the opening side of the second part 12, so that an accommodation space is jointly defined by the first part 11 and the second part 12. The first part 11 and the second part 12 may respectively be a hollow structure having one side opening, and the opening side of the first part 11 is covered on the opening side of the second part 12. It should be understood that the box body 10 formed by the first part 11 and the second part 12 may be in various shapes, such as a cylinder, a cuboid and the like.

In the battery 100, the cell module 20 includes a plurality of cells 21, and the cells 21 may be connected in series, in parallel or in series-and-parallel. The plurality of cell modules 20 may be connected in series, in parallel or in series-and-parallel. Among them, connected in series-and-parallel refers to that a series connection and a parallel connection are both included. The plurality of cell modules 20 may be directly connected in series, in parallel or in series-and-parallel, and then an entirety composed of the plurality of cell modules 20 is housed in the box body 10.

The battery monitor system 30 is also disposed inside the box body 10, for example, the battery monitor system 30 may be disposed on the top of the first part 11 or the bottom of the second part 12, or may also be disposed on a side of the first part 11 and/or the second part 12. In FIG. 2, the battery monitor system 30 is disposed on the top of the first part 11 for exemplary illustration. It can be understood that a wire connection is also provided between the battery monitor system 30 and each cell module 20 to collect electrical signals of the cell module 20 during operation. The components of the battery monitor system 30 may also be dispersed among the cell modules 20, which can facilitate the collection of detection signals. The location of the battery monitor system 30 inside the battery 100 will not be limited in here. The battery monitor system 30 can monitor the battery in real time for 24 hours with low power consumption, and when an abnormality is detected, the entire battery monitor system 30 can be automatically waken up to perform the all-round monitoring.

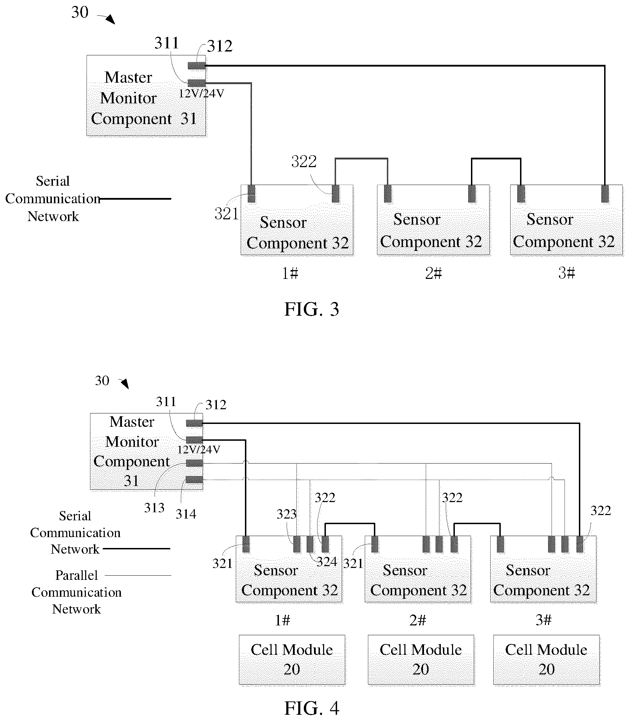

According to some embodiments of the present application, referring to FIG. 3, the battery monitor system 30 includes a master monitor component 31 and N sensor components 32. The master monitor component 31 and the N sensor components 32 are connected via a serial communication network. It should be noted that, in FIG. 3, only three sensor components 32 are shown for exemplary illustration. In this embodiment, the master monitor component 31 is a main part of the system, which may be a conventional battery management system (BMS). The structure and functions of the BMS have been described in the above, and will not be described in detail here.

The sensor component 32 may be a sensor selected according to a monitoring item. For example, the sensor component 32 may be a smoke sensor, an air pressure sensor, or a gas sensor when it is necessary to monitor whether a thermal runaway event occurs. Among them, the smoke sensor may collect an aerosol concentration value, and the aerosol concentration value will increase abnormally when the battery is overheated and caught fire, indicating that a thermal runaway event has occurred. The air pressure sensor may collect an air pressure value, and the air pressure value will also increase abnormally when the heat inside the battery accumulates, indicating that a thermal runaway event has occurred. The gas sensor may collect a concentration value of a certain gas, such as the concentration value of carbon dioxide, and it is indicated that a thermal runaway event has occurred when the concentration value of carbon dioxide inside the battery increases abnormally.

The number N of sensor components 32 may be set according to actual conditions. For example, the number N of sensor components 32 may be consistent with the number of cell modules, so that the sensor components 32 are corresponded to the cell modules one by one, and one sensor component 32 monitors one cell module. In some implementations, one sensor component 32 may also monitor one, two or more cell modules, etc., which will not be limited in here. It can be understood that a micro control unit (MCU) of the sensor component 32 performs periodic detection at regular intervals, for example, the aerosol concentration value is detected by the smoke sensor at a period of 1S or 2S. Thereby, the sensor component 32 is enabled to perform a 24-hour real-time monitoring at low power consumption.

The serial communication network is equivalent to a communication line connecting the master monitor component 31 and the N sensor components 32 in series. In the serial communication network, a signal is relayed from one component to the next adjacent component, for example, components A, B, C, and D are connected in series, then a signal can be sent by component A to component B, a signal can be sent by component B to component C, a signal can be sent by component C to component D, and a signal can be sent by component D to component A, but the signal sent by component A cannot be directly received by component C. It can be understood that the components A, B, C, and D here may include one master monitor component and three sensor components. In the serial communication network, the serial communication network will be interrupted when the communication connection is disconnected at any one of the components.

When it is detected by any sensor component i among the N sensor components (that is, the i-th sensor component, 1≤i≤N) that the cell module corresponding to this sensor component is abnormal, a wake-up signal is sent by the i-th sensor component via the serial communication network, the (i+1)-th sensor component is awakened upon receiving the wake-up signal via the serial communication network, and the wake-up signal is also sent by the (i+1)-th sensor component via the serial communication network, and then the (i+2)-th sensor component is awakened upon receiving the wake-up signal via the serial communication network, and the wake-up signal is also sent via the serial communication network, and so on, so that the other sensor components subsequent to the i-th sensor component are awakened in sequence. It can be understood that the awakened N-th sensor component will also send the wake-up signal via the serial communication network to enable the master monitor component located behind the N-th sensor component to be woken up upon receiving the wake-up signal sent by the N-th sensor component. It can be understood that the sensor component located adjacent to one side of the master monitor component may be regarded as the 1-st sensor component, and the sensor component located adjacent to the other side of the master monitor component may be regarded as the N-th sensor component. Here, the i-th, (i+1)-th and (i+2)-th sensor components are intended only to exemplarily illustrate the wake-up in sequence, and the number of the sensor components will not exceed N.

In some embodiments, the wake-up signal may be a high-level signal. The sensor component or the master monitor component may be awakened after receiving a high-level signal on the serial communication network. For example, the master monitor component is awakened after receiving the high-level signal on the serial communication network, that is, the master monitor component is switched from the sleep mode (that is, the standby mode that is powered on but is not in operation) to a wake-up mode. It can be understood that the wake-up mode of the master monitor component is a normal operation mode. For another example, any one of the sensor components is awakened after receiving the high-level signal on the serial communication network, and a wake-up signal is sent by this awakened sensor component, that is, waking up the sensor component is equivalent to waking up a signal sending unit of the sensor component.

Therefore, in case that an abnormality is detected by any one of the sensor components, a wake-up signal is sent to the serial communication network, that enables the master monitor component to be woken up in time when the battery is abnormal, so as to perform a comprehensive monitoring and report abnormal faults.

That is to say, for the above battery monitor system, in case that the master monitor component is in the wake-up mode, the master monitor component and the N sensor components can jointly monitor abnormal conditions of each cell module in the battery in an all-round way. In case that the master monitor component is in the sleep mode, the N sensor components periodically monitor abnormalities, and the power consumption is lower. In case that an abnormality is detected by any one of the sensor components, the subsequent sensor components can be awakened in reverse sequence via the serial communication network, and then the master monitor component can be awakened by the last sensor component to conduct the comprehensive monitoring and report abnormal faults. Thus, the safety of the battery can also be monitored by the battery monitor system in real time with low power consumption even when the battery monitor system is in the sleep mode.

The aforementioned serial communication network adopts a daisy chain communication according to some embodiments of the present application.

In the daisy chain communication, the components are connected in series by a daisy chain, that is, the components are connected hand in hand to form a closed loop of communication. Daisy chain refers to the serial wiring of multiple components in a sequence, allowing signals to be relayed from one component to another adjacent one within the chain.

The daisy chain communication has advantages of low cost and high data synchronization, but any communication failure between components will cause the entire network communication to be interrupted.

In this embodiment, the serial communication network adopts the daisy chain communication, that is, the master monitor component and the N sensor components are connected hand in hand by daisy chain to facilitate the transmission of wake-up signals. In case that a wake-up signal is sent by one sensor component to the serial communication network, other components can be awakened in turn.

According to some embodiments of the present application, referring to FIG. 3, the master monitor component 31 includes a first pin 311 and a second pin 312. The first pin 311 and the second pin 312 are in connection with the serial communication network, respectively. The first pin 311 is configured to send a wake-up signal, and the second pin 312 is configured to receive a wake-up signal.

A sensor component 32 includes a third pin 321 and a fourth pin 322. The third pin 321 and the fourth pin 322 are in connection with the serial communication network, respectively. The third pin 321 is configured to receive a wake-up signal, and the fourth pin Pin 322 is configured to send a wake-up signal. As shown in FIG. 3, the master monitor component 31 and three sensor components 32 are shown connected in serial communication. Through the daisy chain, the first pin 311 of the master monitor component 31 is in connection with the third pin 321 of a 1-st sensor component 32, the fourth pin 322 of the 1-st sensor component 32 is in connection with a third pin 321 of a 2-nd sensor component 32, a fourth pin 322 of the 2-nd sensor component 32 is in connection with a third pin 321 of a 3-rd sensor component 32, and a fourth pin 322 of the 3-rd sensor component 32 is in connection with the second pin 312 of the master monitor component 31.

In the sleep mode of the master monitor component 31, if an abnormality is detected by the 1-st sensor component 32, a electrical level at the fourth pin 322 of the 1-st sensor component 32 is pulled high, in this case, the high-level signal is equivalent to the wake-up signal. Since the fourth pin 322 of the 1-st sensor component 32 is connected to the third pin 321 of the 2-nd sensor component 32, the wake-up signal is received by the third pin 321 of the 2-nd sensor component 32 and the electrical level at the third pin 321 of the 2-nd sensor component 32 is pulled high, thereby the 2-nd sensor component 32 is awakened. After the 2-nd sensor component is awakened, the electrical level at the fourth pin 322 of the 2-nd sensor component 32 is pulled high (which is equivalent to that the wake-up signal is sent). Since the fourth pin 322 of the 2-nd sensor component 32 is connected to the third pin 321 of the 3-rd sensor component 32, the wake-up signal is received by the third pin 321 of the 3-rd sensor component 32, and the electrical level at the third pin 321 of the 3-rd sensor component 32 is pulled high, thereby the 3-rd sensor component 32 is awakened. After the 3-rd sensor component 32 is awakened, the electrical level at the fourth pin 322 of the 3-rd sensor component 32 is pulled high (which is equivalent to that the wake-up signal is sent). Since the fourth pin 322 of the 3-rd sensor component 32 is connected to the second pin 312 of the master monitor component 31, the wake-up signal (i.e., the high-level signal) is received by the second pin 312 of the master monitor component 31, the electrical level at the second pin 312 of the master monitor component 31 is pulled high, thereby the sleep mode is switched to the wake-up mode. In this embodiment, the master monitor component and each sensor component are connected through pins and daisy chains to form a serial communication, the structure is simple, and no special requirement is needed for interfaces of the master monitor component and the sensor components, thus, a strong universal applicability can be achieved. For example, when the master monitor component is a BMS and the sensor component is an air pressure sensor, most BMS and air pressure sensors on the market are connectable through their own pins and daisy chains.

According to some embodiments of the present application, referring to FIG. 4, the master monitor component 31 and the N sensor components 32 are also connected via a parallel communication network. coding coordination information is sent by the master monitor component 31 to the parallel communication network, and the N sensor components 32 are configured to perform an identifier encoding according to the coding coordination information.

The parallel communication network is equivalent to communication lines connecting the master monitor component 31 and N sensor components 32 in parallel. In the parallel communication network, in case a signal is sent by one component, the signal can be received simultaneously by other components. For example, in a parallel communication network, in case that a signal is sent by the master monitor component 31, the signal can be simultaneously received by the N sensor components 32. In a parallel communication network, in case that a communication connection of any component is disconnected, the communication connections of other components will not be affected.

In this embodiment, each sensor component is encoded with an identifier when the battery monitor system is in an initialization stage, where the identifier is the identity document (Identity document, ID) of each sensor component. Thus, when a signal is sent by a sensor component to the parallel communication network, the master monitor component and other sensor components can know which senor component has sent the signal. Therefore, in case that an abnormality is detected by a sensor component and a signal reflecting an abnormality is sent by the sensor component to the parallel communication network, the master monitor component may locate the abnormal fault according to the signal reflecting the abnormality. Here, the signal may be a message, and a corresponding identifier is carried in the message.

It can be understood that the identifier encoding is performed during the initialization stage of the battery monitor system. After the encoding is completed, each sensor component stores its own identifier. Subsequently, each time the system is powered on, the sent message carries the identifier of the corresponding the sensor component.

To encode the identifiers of the N sensor components, the coding coordination information is sent by the master monitor component to the parallel communication network, after the battery monitor system is powered on during the initialization stage, and then the N sensor components are configured to respectively perform the identifier encoding according to the coding coordination information.

Inhere, an overall coding situation of N sensor components is reflected by the coding coordination information, for example, the coding coordination information includes the number N of sensor components, and a range of identifier, etc. Thus, the sensor component may select one in the range of identifier as its own identifier according to the coding coordination information. For example, the master monitor component and 10 sensor components are all in the wake-up mode, and the coded coordination information is sent by the master monitor component, where the coding coordination information includes the number of sensor components, such as 10, and the range of identifier, such as "01-10". The 10 sensor components respond to the coding coordination information in order to encode the identifier. For example, the 1-st sensor component waits for 1 second after receiving the coding coordination information and takes "01" as its own identifier, and sends a message "0x101" to the parallel communication network. The 2-nd sensor component waits for 2 seconds after receiving the coding coordination information and takes "02" as its own identifier according to the quantity 10, the range "01-10" and the message "0x101", and sends a message "0x102" to the parallel communication network. By analogy, the identifier of each sensor component is encoded in sequence through a setting of waiting for a delay.

In this embodiment, the master monitor component and N sensor components are also connected via a parallel communication network. In the initialization stage of the battery monitor system, the coding coordination information can be sent by the master monitor component to the parallel communication network, and the identifiers of the N sensor components can be encoded according to the coding coordination information, so that automatic coding can be realized and the offline test and calibration process can be omitted.

According to some embodiments of the present application, the coded coordination information is sent by the master monitor component to a parallel communication network, and a wake-up signal is also sent by the master monitor component to a serial communication network. In the initialization stage of the battery monitor system, the master monitor component is in the wake-up mode, and each sensor component is in the sleep mode. To automatically encode each sensor component, the master monitor component is configured to simultaneously send the coding coordination information to the parallel communication network and send the wake-up signal to the serial communication network.

The 1-st sensor component is awakened after receiving the wake-up signal, and the awakened 1-st sensor component is configured to perform an identifier encoding according to the coding coordination information and the identifier information in the parallel communication network. It can be understood that, since the first sensor is the first one to be awakened for the identifier encoding, no identifier information is sent by the sensor component in the parallel communication network, so that the 1-st sensor component is encoded according to the number of sensor components and the range of identifier that are obtainable from the coding coordination information. For example, an initial value in the range of identifier is used as the identifier of the first sensor component. After the encoding is completed, a first identifier information is sent to the parallel communication network, and the wake-up signal is sent to the serial communication network, where the identifier of the 1-st sensor component is reflected by the first identifier information.

The 2-nd sensor component is awakened after receiving the wake-up signal sent by the 1-st sensor component, and the awakened 2-nd sensor component is configured to perform the identifier encoding according to the coding coordination information and the identifier information in the parallel communication network. It can be understood that, at this time, only the identifier information (that is, the first identifier information) sent by the 1-st sensor component is in the parallel communication network, so that the number of sensor components and the range of identifier are obtainable by the 2-nd sensor component according to the coding coordination information, and the identifier of the 1-st sensor component is obtainable from the first identifier information, and then the 2-nd sensor component is encoded based on the above information. For example, the identifier of the 2-nd sensor component is within the above range of identifier, an is different from the identifier of the 1st sensor component. After the encoding is completed, a second identifier information is sent to the parallel communication network, and the wake-up signal is sent to the serial communication network.

By analogy, for any one (i.e., the i-th sensor component) of the N sensor components except the last sensor component, the i-th sensor component is awakened after receiving the wake-up signal, and the awakened i-th sensor component is configured to perform the identifier encoding according to the coding coordination information and the identifier information in the parallel communication network. For example, the identifier of the i-th sensor component is within the above range of identifier, and is different from the identifiers of the previously encoded sensor components. After the encoding is completed, an i-th identifier information is sent to the parallel communication network, and simultaneously, the wake-up signal is sent to the serial communication network to wake up the (i+1)-th sensor component, and the awakened (i+1)-th sensor component is then encoded in the above manner, for example, the identifier of the (i+1)-th sensor component is within the above range of identifier, and is different from the identifiers of the previously encoded sensor components. After the encoding is completed, the (i+1)-th identifier information is sent to the parallel communication network, and the wake-up signal is sent to the serial communication network, to wake up the subsequent sensor components in turn, so that each sensor component is encoded with an identifier according to the coding coordination information and the identifier information in the parallel communication network.

In this embodiment, in the initialization stage of the battery monitor system, the coding coordination information is sent by the master monitor component to the parallel communication network and the wake-up signal is sent to the serial communication network, so that N sensor components are awakened in turn, and the identifier encoding is performed according to the coding coordination information and the identifier information in the parallel communication network to realize an automatic encoding, which is simple and convenient without additional settings.

According to some embodiments of the present application, the aforementioned coding coordination information includes the number N of sensor components and a numerical range. The initial value of the numerical range is taken as the identifier of the awakened 1-st sensor component. The identifier of the awakened j-th sensor component is equal to the identifier of the j-lth sensor component plus 1, where 2≤j≤N.

For example, after the master monitor system is initialized, the message "0x100" is broadcast in real time in the parallel communication network, and a wake-up signal is sent to the serial communication network. Here, the number N=3 of sensor components and the numerical range [1, 3] are carried by the message "0x100". To be specific, as shown in FIG. 4, the first pin 311 of the master monitor component 31 is a high-side output, and outputs a voltage of 12V or 24V, this voltage is transmitted to the 1-st sensor component, and the third pin of the 1-st sensor component pin is pulled high, thereby enabling the 1-st sensor component pin to be waken up.

The 1-st sensor component after waking up uses the initial value "1" of the numerical range [1, 3] as its own identifier, and sends a message "0x101" to the parallel communication network. Meanwhile, the voltage at the fourth pin of the 1-st sensor component is pulled high, that is, the wake-up signal is output, and then the voltage at the third pin of the 2-nd sensor component is pulled high, thereby enabling the 2-nd sensor component to be woken up.

After the 2-nd sensor component is awakened, the message "0x100" and the message "0x101" are received, and from these two messages, it can be obtained that the total number of sensor components is 3, the numerical range is [1, 3], and the identifier of the 1-st sensor component is "1". Thus, the 2-nd sensor component checksums and designs its own identifier as "1+1=2", that is, the identifier of 2-st sensor component is equal to the identifier of 1-st sensor component plus 1, and then the message "0x102" is sent by the 2-nd sensor component to the parallel communication network. Meanwhile, the voltage at the fourth pin of the 2-nd sensor component is pulled high, that is, the wake-up signal is output, and the voltage at the third pin of the 3-rd sensor component is pulled high, thereby enabling the 3-rd sensor component to be woken up.

After the 3-rd sensor component is awakened, the message "0x100", the message "0x101" and the message "0x102" are received, and from the three messages, it can be obtained that the total number of sensor components is 3, and the numerical range is [1, 3], and the identifier of the 1-st sensor component is " 1", and the identifier of the 2-nd sensor component is "2". Thus, the 3-rd sensor component checksums and designs its own identifier as "2+1=3", that is, the identifier of the 3-nd sensor component is equal to the identifier of the 2-nd sensor component plus 1, and the message "0x103" is sent to the parallel communication network. Meanwhile, the voltage at the fourth pin of the 3-nd sensor component is pulled high, that is, the wake-up signal is output, so as to notify the master monitor component that the automatic encoding of each sensor component in the entire system is completed.

In this embodiment, N sensor components are awakened in sequence, and the identifiers are sequentially incremented by 1 during encoding, so that the identifiers will not be repeated, and the encoding process is simple and less error-prone.

According to some embodiments of the present application, after the identifiers of the N sensor components are encoded, the master monitor component is configured to verify whether the number of identifier information in the parallel communication network matches the number N of sensor components, and determine an occurrence of encoding failure if the number of identifier information in the parallel communication network is not matched with the number N of sensor components, re-send the wake-up signal to the serial communication network, to enable the N sensor components to re-perform the identifier encoding. The master monitor component is configured to determine an occurrence of an automatic encoding failure if the number of successive encoding failures reaches a preset number. When the encoding of the N-th sensor component is completed, a voltage at the fourth pin of the N-th sensor component is pulled high, to output a wake-up signal, thereby notifying the master monitor component that the automatic encoding of each sensor component in the entire system is completed. During the encoding process, it is determined that the encoding is completed when the wake-up signal sent by the N-th sensor is received by the master monitor component. Thus, the master monitor component is triggered to check the number of identifier information and the number N of sensor components in the parallel communication network. It can be understood that, in case that all the N sensor components are encoded successfully, each sensor component will send its own identifier information to the parallel communication network after the encoding is successful, then N identifier information will be included in the parallel communication network. In case that some sensor components are not encoded successfully, then the identifier information of those sensor components will not be sent to the parallel communication network, and the number of identifier information in the parallel communication network will be less than N.

Therefore, the master monitor component can determine whether the encoding of the entire battery monitor system is successful according to the determination on whether the number of identifier information in the parallel communication network matches the number N of sensor components. If the number of identifier information in the parallel communication network is not matched with the number N of sensor components, for example, the number of sensor components is 3 while only 2 identifier information are received by the master monitor component, then it is determined that the encoding is failed. And the encoding is re-initialized, that is, the wake-up signal is re-sent to the serial communication network, to enable the N sensor components to re-perform the identifier encoding.

If the number of successive encoding failures reaches a preset number, then it is determined by the master monitor component that an automatic encoding failure occurs. Those skilled in the art may set the preset number of times according to actual needs, for example, the preset number of times may be 3 times, that is, if the encoding by the battery monitor system fails for 3 consecutive times, then the encoding will be stopped, and the master monitor component will report the automatic encoding failure to remind operators to carry out maintenance.

In this embodiment, after the encoding of the N-th sensor component is completed, the master monitor component verifies whether the encoding of the entire system is successful through a comparison of the number of identifier information in the parallel communication network and the number of sensor components. If the number of successive encoding failures reaches a preset number, then an automatic encoding failure will be reported, which enables the encoding process to be more intelligent, and will not cause encoding failure due to accidental interference factors, the reliability is higher.

According to some embodiments of the present application, the master monitor component is configured to, if the wake-up signal sent by the N-th sensor component is not received by the master monitor component, determine that the serial communication network is faulty.

For example, if N=3, the master monitor component has only received the message 0x101 and the message 0x102, and the wake-up signal sent by the 3-rd sensor component is not received, then it is indicated that the serial line between the 2-nd sensor component and the 3-rd sensor component has a fault, the 3-rd sensor component cannot be awakened, resulting in that the 3-rd sensor component cannot be encoded normally. Thus, it is determined that the serial communication network is faulty. It is can be understood that, if the master monitor component has received the message 0x101, message 0x102 and message 0x103, but does not receive the wake-up signal sent by the 3-rd sensor component, then it is indicated that the serial line between the 3-rd sensor component and the master monitor component has a fault.

In some embodiments, the master monitor component is configured to, if the wake-up signal sent by the N-th sensor component is received by the master monitor component and the master monitor component verifies that the number of identifier information in the parallel communication network is not matched with the number N of sensor components, determine that the parallel communication network is faulty. If the wake-up signal sent by the N-th sensor component is received by the master monitor component, it is indicated that the serial communication network is normal, that is, each sensor component is awakened and the encoding is successful. In this case, if the number of the identifier information in the parallel communication network is not matched with the number N of sensor components, indicating that at least one sensor component fails to send the identifier information to the parallel communication network, and then it can be determined that the parallel communication network is faulty. For example, if the message 0x101 and the message 0x103 are received by the master monitor component while the message 0x102 is not received by the master monitor component, it is indicated that the communication between the 2-nd sensor component and the parallel communication network is lost, that is, a communication fault occurs at the 2-nd sensor component in the parallel communication network.

In this embodiment, the communication fault can be located based on determinations on whether a wake-up signal is sent by the N-th sensor component, and whether the number of identifier information in the parallel communication network is matched with the number of sensor components, which is convenient for operators to repair.

According to some embodiments of the present application, the parallel communication network is a controller area network (Controller Area Network, CAN), referred to as a CAN communication network, which has the advantages of strong real-time performance, strong anti-electromagnetic interference capability, and low cost.

In this embodiment, a controller area network is used to connect the master monitor component and each sensor component in parallel communication, so that the signals sent by each component can be transmitted in real time.

According to some embodiments of the present application, the master monitor component also includes a fifth pin and a sixth pin. The fifth pin is in connection with a first communication line in the parallel communication network, and the sixth pin is in connection with a second communication line in the parallel communication network. A sensor component also includes a seventh pin and an eighth pin. The seventh pin is in connection with the first communication line, and the eighth pin is in connection with the second communication line.

As shown in FIG. 4, the master monitor component 31 and three sensor components 32 are connected via a parallel communication network. The parallel communication network includes a first communication line and a second communication line, which constitute main lines of the CAN. The fifth pin 313 of the master monitor component 31 is connected to the first communication line, and the sixth pin 314 of the master monitor component 31 is connected to the second communication line. The seventh pins 323 of the three sensor components are respectively connected to the first communication line, and the eighth pins 324 of the three sensor components are respectively connected to the second communication line.

Therefore, when the master monitor component or any one of the three sensor components sends information to the parallel communication network, other components can receive the information in real time.

The pins are connected with the CAN bus to form a parallel communication, the structure is simple, and no special requirement is needed for interfaces of the master monitor component and the sensor components, thus, a strong universal applicability can be achieved. For example, when the master monitor component is a BMS and the sensor component is an air pressure sensor, most BMS and air pressure sensors on the market can be connected to the CAN bus through their own pins.

According to some embodiments of the present application, referring to FIG. 4, the battery includes three cell modules 20, and the battery monitor system 30 includes a master monitor component 31 and three sensor components 32.

The three sensor components 32 are respectively a smoke sensor, an air pressure sensor and a gas sensor, all of which can detect whether the cell module 20 has thermal runaway. The three sensor components 32 correspond to the three cell modules 20 one by one, and one sensor component 32 is configured to periodically monitor whether a cell module 20 has thermal runaway. The master monitor component 31 may be a conventional battery management system (BSM). The master monitor component 31 is disposed inside the battery, and the three sensor components 32 are arranged correspond to the corresponding cell modules 20, respectively.

The serial communication connection between the master monitor component 31 and the three sensor components 32 is realized through the daisy chain communication, and the parallel communication connection between the master monitor component 31 and the three sensor components 32 is also realized through the CAN main line.

In the initialization stage of the battery monitor system 30, the master monitor component 31 is in the wake-up mode, and each sensor component 32 is in the sleep mode. To automatically encode each sensor component 32, the coding coordination information is sent by the master monitor component 31 to the parallel communication network, and simultaneously, and the wake-up signal is sent by the same to the serial communication network.

Specifically, after the master monitor system 30 is initialized, the message "0x100" is broadcast in real time in the parallel communication network, and the wake-up signal is sent to the serial communication network. In here, the number N=3 of sensor components and the numerical range [1, 3] are carried by the message "0x100". Specifically, as shown in FIG. 4, the first pin 311 of the master monitor component 31 is a high-side output, and outputs a voltage of 12V or 24V, the voltage is transmitted to the 1-st sensor component, and the voltage at the third pin 321 of the 1-st sensor component 32 is pulled high, thereby the 1-st sensor component pin is waken up.

The 1-st sensor component 32 after waking up uses the initial value "1" of the numerical range [1, 3] as its own identifier, and sends a message "0x101" to the parallel communication network. Meanwhile, the voltage at the fourth pin 322 of the 1-st sensor component 32 is pulled high, that is, the wake-up signal is output, and then the voltage at the third pin 311 of the 2-nd sensor component 32 is pulled high, thereby enabling the 2-nd sensor component 32 to be woken up.

After the 2-nd sensor component 32 is awakened, the message "0x100" and the message "0x101" are received, from these two messages, it can be obtained that the total number of sensor components is 3, the numerical range is [1, 3], and the identifier of the 1-st sensor component is "1". Thus, the 2-nd sensor component 32 checksums and designs its own identifier as "1+1=2", that is, the identifier of 2-st sensor component is equal to the identifier of 1-st sensor component plus 1, and then the message "0x102" is sent by the 2-nd sensor component to the parallel communication network. Meanwhile, the voltage at the fourth pin 322 of the 2-nd sensor component 32 is pulled high, that is, the wake-up signal is output, and the voltage at the third pin 321 of the 3-rd sensor component 32 is pulled high, thereby enabling the 3-rd sensor component to be woken up.

After the 3-rd sensor component 32 is awakened, the message "0x100", the message "0x101" and the message "0x102" are received, and from these three messages, it can be obtained that the total number of sensor components is 3, and the numerical range is [1, 3], and the identifier of the 1-st sensor component is " 1", and the identifier of the 2-nd sensor component is "2". Thus, the 3-rd sensor component checksums and designs its own identifier as "2+1=3", that is, the identifier of the 3-nd sensor component is equal to the identifier of the 2-nd sensor component plus 1, and the message "0x103" is sent to the parallel communication network. Meanwhile, the voltage at the fourth pin 322 of the 3-nd sensor component is pulled high, that is, the wake-up signal is output, so as to notify the master monitor component that the automatic encoding of each sensor component in the entire system is completed.

In the sleep mode of the master monitor component, if an abnormality is detected by the 1-st sensor component, an electrical level at the fourth pin of the 1-st sensor component is pulled high, in this case, the high-level signal is equivalent to the wake-up signal. Since the fourth pin of the 1-st sensor component is connected to the third pin of the 2-nd sensor component, the wake-up signal is received by the third pin of the 2-nd sensor component and the electrical level at the third pin of the 2-nd sensor component is pulled high, thereby the 2-nd sensor component is awakened. The electrical level at the fourth pin of the awakened 2-nd sensor component is pulled high (which is equivalent to that the wake-up signal is sent). Since the fourth pin of the 2-nd sensor component is connected to the third pin of the 3-rd sensor component, the wake-up signal is received by the third pin of the 3-rd sensor component, and the electrical level at the third pin of the 3-rd sensor component is pulled high, thereby the 3-rd sensor component is awakened. The electrical level at the fourth pin of the awakened 3-rd sensor component is pulled high (which is equivalent to that the wake-up signal is sent). Since the fourth pin of the 3-rd sensor component is connected to the second pin of the master monitor component, the wake-up signal (i.e., the high-level signal) is received by the second pin of the master monitor component, the electrical level at the second pin of the master monitor component is pulled high, thereby the sleep mode is switched to the wake-up mode, to perform a comprehensive monitoring.

For the above battery monitor system, the master monitor component and the 3 sensor components are also connected via a parallel communication network. In the initialization stage of the battery monitor system, the coding coordination information can be sent by the master monitor component to the parallel communication network, and the identifiers of the three sensor components can be encoded according to the coding coordination information, so that automatic coding can be realized and the offline test and calibration process can be omitted.

In case that the master monitor component is in the wake-up mode, the master monitor component and the three sensor components can jointly monitor abnormal conditions of each cell module in the battery in an all-round way. In case that the master monitor component is in the sleep mode, the three sensor components periodically monitor abnormalities, and the power consumption is lower. In case that an abnormality is detected by any one of the sensor components, the subsequent sensor components can be awakened in reverse sequence via the serial communication network, and then the master monitor component can be awakened by the last sensor component to conduct the comprehensive monitoring and report abnormal faults. Thus, the safety of the battery can also be monitored by the battery monitor system in real time with low power consumption even when the battery monitor system is in the sleep mode. According to some embodiments of the present application, the present application also provides a battery which includes the aforementioned battery monitor system and N cell modules. The battery monitor system includes a master monitor component and N sensor components. One sensor component is arranged on one cell module, such as on a surface of the cell module, to periodically monitor whether the cell module is abnormal. The master monitor component includes a BMS, and the sensor component may be provided according to a monitoring project. For example, the sensor component, when monitoring a thermal runaway failure, may be a smoke sensor, an air pressure sensor or a gas sensor, etc. The structure and function of the battery monitor system are the same as those of the battery monitor system in the foregoing embodiments, and will not be described in detail here.

In the above embodiments, the battery monitor system can monitor the battery in real time for 24 hours with low power consumption. When an abnormality is detected, the entire battery monitor system can be automatically awakened to perform all-round monitoring, making the battery more reliable and safer. According to some embodiments of the present application, the present application also provides an electric device which includes the aforementioned battery. The electrical device may be an electric vehicle or an electric logistics vehicle.

In the above embodiments, based on the reliable and safe characteristics of the battery, the electric device can reduce losses caused by battery failure.

Finally, it should be noted that: the above embodiments are only used to illustrate the technical solutions of the present application, and are not intended to limit the present application. Although the present application has been described in detail with reference to the foregoing embodiments, those of ordinary skills in the art should understand that it is still possible to modify the technical solutions described in the foregoing embodiments, or perform equivalent replacements for some or all of the technical features. These modifications or replacements do not make the essence of the corresponding technical solutions deviate from the technical solutions of the various embodiments of the present application, thus should all be covered by the scope of the claims and description of the present application. In particular, the technical features mentioned in the various embodiments may be combined in any manner as long as there is no structural conflict. The present application is not limited to the specific embodiments disclosed herein, and includes all technical solutions falling within the scope of the claims.

## Claims

1. A battery monitor system, comprising N sensor components and a master monitor component that are connected via a serial communication network,
wherein,
the N sensor components are configured to periodically monitor whether a corresponding cell module is abnormal, and N is an integer being greater than or equal to 2;
if it is detected by an i-th sensor component that the cell module corresponding to the i-th sensor component is abnormal, then a wake-up signal is sent by the i-th sensor component via the serial communication network to enable other sensor components subsequent to the i-th sensor component within the serial communication network to be awakened in sequence, and the master monitor component is awakened by an awakened N-th sensor component, wherein, 1≤i≤N.

2. The system according to claim 1, wherein the serial communication network adopts a daisy chain communication.

3. The system according to claim 2, wherein the master monitor component comprises a first pin and a second pin, and the first pin and the second pin are respectively connected with the serial communication network, the first pin is configured to send a wake-up signal, and the second pin is configured to receive the wake-up signal;
each sensor component comprises a third pin and a fourth pin, the third pin and the fourth pin are respectively connected with the serial communication network, the third pin is configured to receive the wake-up signal, and the fourth pin is configured to send the wake-up signal.

4. The system according to any one of claims 1-3, wherein the master monitor component and the N sensor components are further connected via a parallel communication network;
the master monitor component is configured to send coding coordination information to the parallel communication network, and the N sensor components are configured to respectively perform an identifier encoding according to the coding coordination information.

5. The system according to claim 4, wherein the coding coordination information is sent by the master monitor component to the parallel communication network, and the wake-up signal is also sent by the master monitor component to the serial communication network;
the i-th sensor component is awakened after receiving the wake-up signal, and the awakened i-th sensor component is configured to perform the identifier encoding according to identifier information in the parallel communication network and the coding coordination information, and send i-th identifier information to the parallel communication network, and send the wake-up signal to the serial communication network, to enable other sensor components subsequent to the i-th sensor component to be woken up in sequence and to perform the identifier encoding according to the identifier information in the parallel communication network and the coding coordination information.

6. The system according to claim 5, wherein the coding coordination information comprises a number N and a numerical range of the sensor components;
a 1-st sensor component after being awakened is configured to use an initial value of the numerical range as an identifier of the 1-st sensor component; and
a j-th sensor component after being awakened is configured to increase the identifier of the (j-1)-th sensor component increased by 1 as an identifier of the j-th sensor component, wherein, 2≤j≤N.

7. The system according to any one of claims 4-6, wherein the master monitor component is configured to verify whether a number of identifier information in the parallel communication network is matched with the number N of the sensor components after the identifier encoding is performed by each of the N sensor components, and determine an encoding failure if the number of identifier information in the parallel communication network is not matched with the number N of the sensor components, and re-send the wake-up signal to the serial communication network, to enable the N sensor components to respectively re-perform the identifier encoding; and
the master monitor component is configured to determine an occurrence of an automatic encoding failure if a number of successive encoding failures reaches a preset number.

8. The system according to claim 7, wherein the master monitor component is configured to, if the wake-up signal sent by the N-th sensor component is not received by the master monitor component, determine that the serial communication network is faulty; and/or
the master monitor component is configured to, if the wake-up signal sent by the N-th sensor component is received by the master monitor component and the master monitor component verifies that the number of identifier information in the parallel communication network is not matched with the number N of the sensor components, determine that the parallel communication network is faulty.

9. The system according to any one of claims 1-8, wherein the parallel communication network is a controller area network.

10. The system according to claim 9, wherein the master monitor component further comprises a fifth pin and a sixth pin, the fifth pin is in connection with a first communication line in the parallel communication network, and the sixth pin is in connection with a second communication line in the parallel communication network;
each sensor component further comprises a seventh pin and an eighth pin, the seventh pin is in connection with the first communication line, and the eighth pin is in connection with the second communication line.

11. A battery, comprising:
the battery monitor system according to any one of claims 1-10; and
N cell modules, wherein the N sensor components are arranged to correspond to the N cell modules respectively, and the master monitor component comprises a battery management system (BMS).

12. An electrical device, comprising the battery according to claim 11.
